Europäisches Patentamt

European Patent Office

Office européen des brevets

(19)

(11) Publication number : **0 523 900 A2**

(12) # EUROPEAN PATENT APPLICATION

(21) Application number : **92306248.3**

(22) Date of filing : **08.07.92**

(51) Int. Cl.$^5$ : **G11B 11/10,** G11B 7/00, G11B 13/04

(30) Priority : **08.07.91 JP 166807/91**
**08.07.91 JP 166808/91**
**08.07.91 JP 166809/91**
**08.07.91 JP 166810/91**

(43) Date of publication of application :
**20.01.93 Bulletin 93/03**

(84) Designated Contracting States :
**DE FR GB IT NL**

(71) Applicant : **MITSUI PETROCHEMICAL**
**INDUSTRIES, LTD.**
**2-5, Kasumigaseki 3-chome Chiyoda-ku**
**Tokyo 100 (JP)**

(72) Inventor : **Tsuzukiyama, Koji, c/o Mitsui**
**Petrochem. Ind. Ltd.**
**580-32, Aza-Taku 2-gou, Nagaura**
**Sodegaura-shi, Chiba 299-02 (JP)**

(74) Representative : **Senior, Alan Murray et al**
**J.A. KEMP & CO., 14 South Square Gray's Inn**
**London WC1R 5LX (GB)**

(54) **method of detecting information from an optical or magnetooptical recording medium, and an optical recording medium.**

(57) The information detecting method of the invention comprises irradiating a recording medium with a linearly polarized light, causing the reflected light from the medium to be transmitted by a λ/4 plate which is configured at an azimuth of approx. 45°, then causing the transmitted light to enter into a polarization beam splitter which is configured at an azimuth of approx. 90° to split the light into a P component and a S component, detecting the P component and the S component individually by a photosensitive detector, and differentially amplifying signals of the P component and the S component by a differential amplifier to detect the reproduced signals based on Kerr ellipticity. According to the information detection method, the reproduced signals can be detected with a high S/N ratio and the optical detection system can be simplified. Further, the information detection method based on the Kerr ellipticity can be used in combination with an information detection method based on Kerr rotation angle or a reflectance, and thereby detection of multi-level signals becomes possible. Hence, recording of information with high density can be attained. According to the invention, moreover, an optical recording medium capable of being recorded with multi-level signals and suitably used for the above-mentioned information detection methods can be provided.

Fig. 1

EP 0 523 900 A2

Jouve, 18, rue Saint-Denis, 75001 PARIS

The present invention relates to a method of detecting information from an magnetooptical recording medium in which a reproduced signal is detected with a high S/N ratio by irradiating a magnetooptical recording medium with a laser spot of a linearly polarized light and utilizing Kerr ellipticity of the reflected light from the medium.

The invention also relates to a method of detecting information from an optical recording medium in which an optical recording medium is irradiated with a laser spot of a linearly polarized light and a reproduced signal based on Kerr ellipticity ($\eta_k$) of the reflected light from the medium is obtained, while a reproduced signal based on Kerr rotation angle ($\theta_k$) of the reflected light is obtained. Hence, recording of information with high density can be attained.

The invention further relates to a method of detecting information from an optical recording medium in which an optical recording medium is irradiated with a laser spot of a linearly polarized light and a reproduced signal based on Kerr ellipticity ($\eta_k$) or Kerr rotation angle ($\theta_k$) of the reflected light from the medium is obtained, while a reproduced signal based on variation of reflectance (R) of the reflected light is obtained. Also, recording of information with high density can be attained.

The invention still further relates to an optical recording medium in which information of 2 bits (four-level signals) can be simultaneously recorded or reproduced on the same spot, and which can be recorded with information with high density.

Magnetooptical recording media have been researched and developped in recent years as large-capacity memories capable of rewriting the recorded information, and they have been almost put into practical use. In such magnetooptical recording media, there is adopted as a means for detecting a reproduced signal a method utilizing Kerr effect, that is, the azimuth (azimuth angle) of a beam of polarized light is rotated by an angle $\theta_k$ (Kerr rotation angle) correspondingly to a magnetization direction of a medium when a linearly polarized incident light is reflected by the medium, and the rotation of the azimuth of polarized light is converted into an optical intensity using an analyzer to obtain the reproduced signal.

By the way, a method of obtaining a reproduced signal utilizing Kerr ellipticity $\eta_k$ is better in some cases than the above-mentioned method of obtaining a reproduced signal utilizing Kerr rotation angle $\theta_k$ of the Kerr effect from the viewpoint of S/N ratio. For example, in a Co/Pt composition modulated film, the Kerr ellipticity $\eta_k$ becomes larger than the Kerr rotation angle $\theta_k$ when a wavelength of a light is less than about 300 nm, as described in "Tech. Digest of MORIS' 91, p. 10, 1991". In such case, since the Kerr ellipticity is larger than the Kerr rotation angle, a reproduced signal of higher S/N ratio can be obtained by utilizing the Kerr ellipticity than by utilizing the Kerr rotation angle.

As such method for obtaining a reproduced signal utilizing the Kerr ellipticity as mentioned above, the following two methods have been proposed. As one method, there is theoretically thought a signal detection which utilizes a fact that when a circular polarized light is incident on a recording medium, an intensity of the light and a phase thereof vary depending on the direction of magnetization (namely, so-called circular dichroism effect of a magnetic material). That is, a method of detecting a differential signal at a bit boundary using a garnet film has been proposed (J. Mag. Soc. Jpn., Vol. 12, pp. 215-218, 1988). However, when a thin film of rare earth transition metal alloy is used as a recording medium, the circular dichroism effect is very small, so that the thin film can be hardly used practically as it is, and an S/N ratio of the obtained signal is not so high.

The other method is a method in which the magnetized information is directly detected as intensity difference of the reflected light, utilizing a fact that when a circular polarized light is incident on a recording medium, an intensity of the reflected light differs depending on the direction of magnetization (J. Mag. Soc. Jpn., Vol. 13, pp 195-198, 1989). In this case, there is a problem that an S/N ratio of the obtained signal is not so high.

Accordingly, there has been a demand for obtaining a reproduced signal utilizing the Kerr ellipticity $\eta_k$ when the Kerr ellipticity is large, but the S/N ratio of the obtained signal is not so high, so that an improvement of the S/N ratio is now desired.

On the other hand, as a reproduced signal detection method for phase change type recording media, there is mainly adopted a method of utilizing such characteristics of the medium that an optical constant of the medium differs between the crystalline phase and the amorphous phase thereby to vary a reflectance of a reflected light when an incident light is reflected by the medium. In this method, the difference of the optical constant between the crystalline phase and the amorphous phase is converted into an intensity of the reflected light, whereby a reproduced signal is obtained.

In the magnetooptical recording media or the optical recording media, there is a demand for recording information with high density, and various developments have been made. In the detection of a reproduced signal, however, any one of a detection method based on the Kerr rotation angle and a detection method based on the Kerr ellipticity has been conventionally used for the magnetooptical recording media, and a detection method based on the variation of reflectance has been conventionally used for the phase change type optical recording media, as described above. That is, only one detection method is adopted for the recording media of one type. In other words, conventionally adopted is such a recording or reproducing system that only a signal of 1 bit is recorded on or reproduced from one spot of an optical recording medium.

On that account, an attempt of providing a recording layer of multi-layer structure in the optical recording medium to conduct recording of multi-level signal has been made (Jpn. J. Appl. Phys., Vol. 28, p. 343, 1989). In this case, however, the detection of the reproduced signal is carried out only by a detection method based on the Kerr rotation angle, so that the signal processing becomes complicated.

For obtaining high-density recording, there are known, at present, multiple recording methods, for example, PHB and holography, but it is difficult to put them into practical use and they are not realistic methods.

Accordingly, it is desired to record an information with high density on optical recording media including both of the magnetooptical recording media and the phase change type optical recording media by means of multi-level recording, and to carry out the signal processing simply. In addition, it is also desired to obtain the reproduced signal based on the Kerr ellipticity with a high S/N ratio.

The present invention is made in the light of such circumstances as mentioned above, and an aim of the invention is to provide a method of detecting information from a magnetooptical recording medium in which a reproduced signal can be obtained with a high S/N ratio utilizing Kerr ellipticity and the constitution of the optical detection system is very simple.

Another aim of the invention is to provide a method of detecting information from an optical recording medium in which a reproduced signal based on Kerr ellipticity can be obtained with a high S/N ratio. By the use of this method, information of multi-level signals can be reproduced, and as a result, recording of information on optical recording media including not only magnetooptical recording media but also phase change type optical recording media can be made with high density.

A further aim of the invention is to provide a method of detecting information from an optical recording medium. By the use of this method, information of multi-level signals can be reproduced, and as a result, recording of information on optical recording media can be made with high density.

A still further aim of the invention is to provide an optical recording medium in which information of 2 bits (four-level records) can be simultaneously recorded on or reproduced from the same spot, and which can be recorded with information with high density.

According to the invention there is provided a method of detecting information recorded on a magnetooptical recording medium, which comprises:

irradiating the magnetooptical recording medium with a linearly polarized light, causing the reflected light from the medium to be transmitted by a quarter-wave plate which is configured at an azimuth of approximately $45°+90°\times n_1$, wherein $n_1$ is an integer, then causing the transmitted light to enter into a polarization beam splitter which is configured at an azimuth of approximately $90°\times n_2$, wherein $n_2$ is an integer, to split the light into a P component and a S component, detecting the P component and the S component individually by a photosensitive detector, and differentially amplifying signals of the P component and the S component by a differential amplifier to detect the reproduced signals.

A first method of detecting information from an optical recording medium according to the invention is a method of detecting information recorded on an optical recording medium, which comprises:

irradiating the optical recording medium with a linearly polarized light, causing the reflected light from the medium to be transmitted by a quarter-wave plate which is configured at an azimuth of approximately $45°+90°\times n_1$, wherein $n_1$ is an integer, then causing the transmitted light to enter into a polarization beam splitter which is configured at an azimuth of approximately $90°\times n_2$, wherein $n_2$ is an integer, to split the light into a P component and a S component, detecting the P component and the S component individually by a photosensitive detector, differentially amplifying signals of the P component and the S component by a differential amplifier, and detecting the reproduced signals based on Kerr ellipticity;

while, detecting the reproduced signals based on variation of a reflectance of the reflected light from the signals of the P component and the S component.

According to a second aspect of the invention there is provided a method of detecting information from an optical recording medium, which comprises:

irradiating the optical recording medium with a linearly polarized light, splitting the reflected light from the medium into a first branch light and a second branch light by a half mirror, causing the first branch light to be transmitted by a quarter-wave plate which is configured at an azimuth of approximately $45°+90°\times n_1$, wherein $n_1$ is an integer, then causing the transmitted light to enter into a polarization beam splitter which is configured at an azimuth of approximately $90°\times n_2$, wherein $n_2$ is an integer, to split the light into a P component and a S component, detecting the P component and the S component individually by a photosensitive detector, and differentially amplifying signals of the P component and the S component by a differential amplifier to detect the reproduced signals based on Kerr ellipticity;

while, causing the second branch light to enter into a polarization beam splitter which is configured at an azimuth of approximately $45°+90°×n_3$, wherein $n_3$ is an integer, to split the light into a P component and a S component, detecting the P component and the S component individually by a photosensitive detector, and differentially amplifying signals of the P component and the S component by a differential amplifier to detect the reproduced signals based on Kerr rotation angle.

According to a third aspect of the invention there is provided a method of detecting information recorded on an optical recording medium, which comprises:

irradiating the optical recording medium with a linearly polarized light, causing the reflected light from the medium to enter into a polarization beam splitter which is configured at an azimuth of approximately $45°+90°×n_3$, wherein $n_3$ is an integer, to split the light into a P component and a S component, detecting the P component and the S component individually by a photosensitive detector, differentially amplifying signals of the P component and the S component by a differential amplifier, and detecting the reproduced signals based on Kerr rotation angle to obtain the information recorded on the optical recording medium;

while, detecting the reproduced signals based on variation of a reflectance of the reflected light from the signals of the P component and the S component to obtain the information recorded on the optical recording medium.

The optical recording medium according to the invention is an optical recording medium which has at least a magnetooptical recording film where information is recorded or reproduced based on a direction of magnetization and a phase changing film where information is recorded or reproduced based on variation of an optical constant caused by phase change between crystalline phase and amorphous phase, formed in this order on a substrate.

The present invention will be further described hereinafter with reference to the following description of exemplary embodiments and the accompanying drawings, in which:

Fig. 1 is a schematic view illustrating an optical detection system used for a signal detection method from a magnetooptical recording medium in one embodiment of the invention.

Fig. 2 is a schematic view illustrating an optical detection system used for a signal detection method from an optical recording medium in the aforementioned first embodiment (method) of the invention.

Fig. 3 is a schematic view illustrating an optical detection system used for a signal detection method from an optical recording medium in the aforementioned second embodiment (method) of the invention.

Fig. 4 is a schematic view illustrating an optical detection system used for a signal detection method from an optical recording medium in the aforementioned third embodiment (method) of the invention.

Fig. 5 is a sectional view of an optical recording medium according to the invention.

The present invention is described below in more detail referring to the attached drawings.

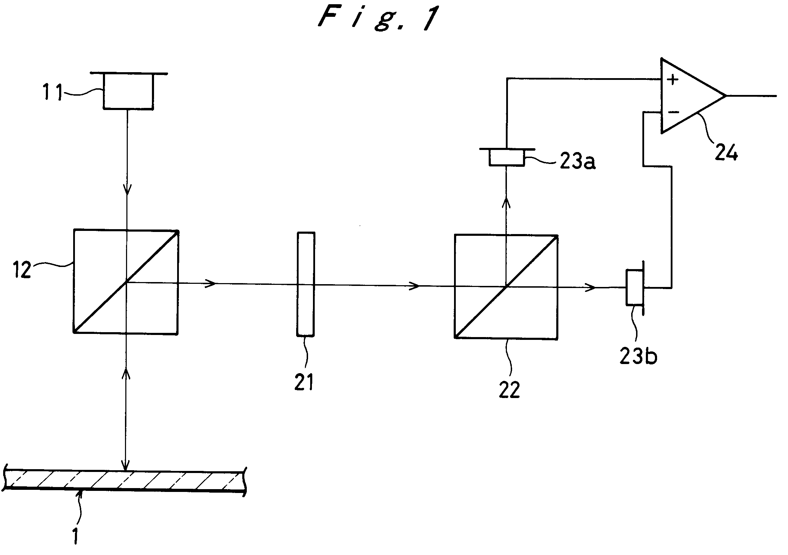

Fig. 1 shows one example of an optical detection system used for the signal detection method from a magnetooptical recording medium according to the invention.

As shown in Fig. 1, for example, a semiconductor laser is released from a laser source 11 and impinges on a beam splitter 12. When a P polarized light of the laser is intended to be used, a S polarized light of the laser is reflected by the beam splitter 12, and only the P polarized light of the laser is transmitted by the beam splitter 12. The term "P polarized light" means a polarized light component within a plane of incidence, the term "S polarized light" means a polarized light component perpendicular to the plane of incidence. The transmitted light from the beam splitter 12 is focused on a magnetooptical recording medium 1 by means of a objective lens (not shown). On the magnetooptical recording medium 1, information is recorded in the form of "0" or "1" depending on the upward direction or downward direction of the magnetization of a magnetic domain. The laser impinges on the magnetooptical recording medium, and thereon the azimuth of polarization of the laser is slightly rotated correspondingly to the direction of the magnetization and reflected.

In the case of detecting the Kerr rotation angle $\theta_k$ in the conventional manner, the rotation is converted into a change of light intensity by means of an analyzer to reproduce information, while in this embodiment the information is reproduced utilizing Kerr ellipticity $\eta_k$, and therefore the optical system used for this embodiment differs from the conventional one. The optical system used for this embodiment is described below.

The reflected light from the magnetooptical recording medium 1 again impinges on a beam splitter 12, and the light is reflected by the beam splitter to be directed to a quarter-wave plate ($\lambda/4$ plate) 21.

The quarter-wave plate 21 is configured in such a manner that an angle $\theta$ between the fast axis of the plate and the azimuth of polarization of the incident laser (referred to as "azimuth" hereinafter) is $40° \leq \theta \leq 50°$, preferably approx. $45°$. When the linearly polarized light is transmitted by the quarter-wave plate 21, a phase difference of $\pi/2$ occurs between the two polarized components (P component and S component) which are orthogonal to each other. That is, the quarter-wave plate 21 is configured so that a quantity of the phase delay $\delta$ thereof satisfies the condition of $\lambda/4-0.05\lambda \leq \delta \leq \lambda/4+0.05\lambda$.

The azimuth $\theta$ of $45°$ is equivalent to the azimuth $\theta$ of $135°$ which differs in 90 degree from the position at which the azimuth $\theta$ is $45°$, so that the azimuth $\theta$ is enough to be $45°+90°×n$ (wherein n is an integer). Hence,

the azimuth $\theta$ is within the range of, $40°+90°\times n_1 \leqq \theta \leqq 50°+90°\times n_1$ (wherein $n_1$ is an integer). The reflected light from the beam splitter is transmitted by such quarter-wave plate 21 as configured above, and thereby the linearly polarized light is converted into a circular polarized light.

The circular polarized light is then directed to a polarization beam splitter 22. The polarization beam splitter 22 is configured so that the azimuth $\theta$ satisfies the condition of $90°\times n_2-5° \leqq \theta \leqq +90°\times n_2+5°$ (wherein $n_2$ is an integer), and preferably the azimuth $\theta$ is $90°\times n_2$. By means of thus configured polarization beam splitter 22, the circular polarized light is split into a P component and a S component.

Then, the P component and the S component are detected by a photosensitive detector 23a and a photosensitive detector 23b, respectively, and the signals of the P component and the S component are differentially amplified by a differential amplifier 24. As a result, reproduced signals are detected.

Next described is a principle on the basis of which reproduced signals can be obtained using a Kerr ellipticity $\eta$ in the constitution of the optical detection system shown in Fig. 1.

An azimuth 0° is determined based on the azimuth of a linearly polarized light which is incident on the magnetooptical recording medium.

When Jones vector of the electric field vector of the incident light is

$$\begin{pmatrix} 1 \\ 0 \end{pmatrix},$$

Jones vector of the reflected light from the magnetooptical recording medium is represented by approx.

$$\begin{pmatrix} 1 \\ \theta_k + i\eta_k \end{pmatrix}$$

Jones matrix of the quarter-wave plate 21 configured at an azimuth of approx. 45° ($n_1 = 0$) is represented by

$$\frac{1}{\sqrt{2}} \begin{pmatrix} 1 & i \\ i & 1 \end{pmatrix}.$$

Jones matrix of the polarization beam spitter 22 configured at an azimuth of 0° ($n_3 = 0$) is represented by

$$\begin{pmatrix} 1 & 0 \\ 0 & 0 \end{pmatrix}$$

and

$$\begin{pmatrix} 0 & 0 \\ 0 & 1 \end{pmatrix},$$

for the P component and the S component, respectively.

Accordingly, when the reflected light from the magnetooptical recording medium 1 is transmitted by the above-mentioned quarter-wave plate 21 and is split into the P component and the S component by means of the polarization beam splitter 22, the electric field vectors, $E_1$ for the p-component and $E_2$ for the s-component, represented as follows.

$$E_1 = \begin{pmatrix} 1 & 0 \\ 0 & 0 \end{pmatrix} \frac{1}{\sqrt{2}} \begin{pmatrix} 1 & i \\ i & 1 \end{pmatrix} \begin{pmatrix} 1 \\ \theta_k + i\eta_k \end{pmatrix}$$

$$= \frac{1}{\sqrt{2}} \begin{pmatrix} 1+i\theta_k-\eta_k \\ 0 \end{pmatrix}$$

$$E_2 = \begin{pmatrix} 0 & 0 \\ 0 & 1 \end{pmatrix} \frac{1}{\sqrt{2}} \begin{pmatrix} 1 & i \\ i & 1 \end{pmatrix} \begin{pmatrix} 1 \\ \theta_k + i\eta_k \end{pmatrix}$$

$$= \frac{1}{\sqrt{2}} \begin{pmatrix} 0 \\ i+\theta_k+i\eta_k \end{pmatrix}$$

Hence, an intensity $I_1$ of the P component and an intensity $I_2$ of the S component are represented as follows.

$$I_1 = |E_1|^2 = \left[ (1-\eta_k)^2 + \theta_k^2 \right] \times \frac{1}{2}$$

$$I_2 = |E_2|^2 = \left[ (1+\eta_k)^2 + \theta_k^2 \right] \times \frac{1}{2}$$

Since differential detection is carried out in this embodiment, the differential signal S is represented by the following equation.

$$S = I_1 - I_2 = 2\eta_k$$

This differential signal S is represented by only the Kerr ellipticity $\eta_k$, so that it is confirmed that the reproduced signal can be obtained by the optical detection system having such constitution as shown in Fig. 1 utilizing the Kerr ellipticity.

As described hereinbefore, the reflected light from the magnetooptical recording medium 1 is transmitted by the quarter-wave plate 21 configured at an azimuth of 45°, and then the light is split into a P component and a S component by means of the polarization beam splitter 22 configured at an azimuth of 0° to detect the reproduced signals, and hence the reproduced signals can be obtained utilizing the Kerr ellipticity $\eta_k$. Further, since the signals of the P component and the S component are differentially amplified to detect the signals, noise in the same phase can be removed and the reproduced signals can be obtained with a high S/N ratio. Furthermore, it can be possible to counterbalance a phase shift between P component and S component generated at optical elements or magnetooptical recording medium, and thereby further improve the S/N ratio of the reproduced signals by inserting a $\lambda/2$ plate configured at a suitable azimuth between the $\lambda/4$ plate and the polarization beam splitter.

As a matter of course, the present invention is by no means restricted to the above-mentioned embodiment.

Details of the magnetooptical recording medium usable for the present invention will be described later again.

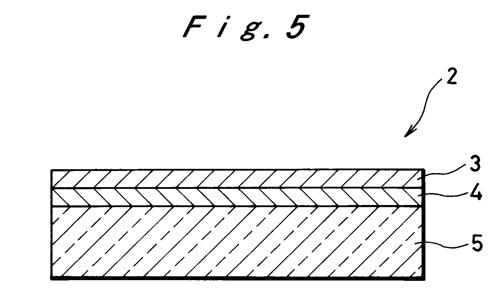

In the above, a method of detecting information utilizing Kerr ellipticity is illustrated. The method of detecting information from a magnetooptical recording medium according to the invention can be used in combination with other known information detection methods. The combination with other known information detection methods makes it possible to detect four-level signals of information as described below. As such multi-level signals can be detected, and recording of information with high density becomes possible. In the combined methods for detecting information, an optical recording medium having the above-mentioned magnetooptical recording film 3 and a phase changing film 4 (described later) as recording films shown in Fig. 5 is employed. Prior to description of details of such recording medium, information detection methods of combined type are described below.

Examples of the information detection methods of combined type are as follows.

1. A method in which information is detected from the magnetooptical recording film 3 based on the Kerr ellipticity ($\eta$) and information is also detected from the phase changing film 4 based on the reflectance (R).

2. A method in which information is detected from the magnetooptical recording film 3 based on the Kerr rotation angle ($\theta_k$) and information is also detected from the phase changing film 4 based on the Kerr ellipticity ($\eta$).

At first, the method 1 is described below in detail.

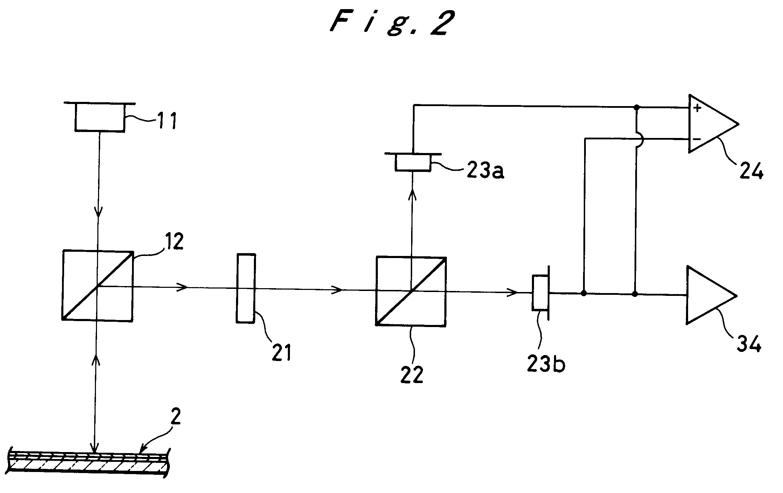

In this signal detection method, such optical system as shown in Fig. 2 is employed. A linearly polarized light released from a laser source 11 impinges on a beam splitter 12. A part of the light is transmitted by the beam splitter 12 and is focused on an optical recording medium 2 by means of a objective lens (not shown). A reflected light from the optical recording medium 2 contains information based on the Kerr ellipticity ($\eta$) in the magnetooptical recording film 3 and information based on the reflectance (R) in the phase changing film 4.

The reflected light is directed to a $\lambda$/4 plate 21 by way of the beam splitter 12, and the linearly polarized light is converted into a circular polarized light, similarly to the optical system shown in Fig. 1. Then, the circular polarized light is directed to a polarization beam splitter 22, and the circular polarized light is split into a P component and a S component by the polarization beam splitter. The P component and the S component are detected by means of photosensitive detectors 23a and 23b, respectively.

Then, the signals of the P component and the S component are differentially amplified by means of a differential amplifier 24, and as a result, reproduced signals based on the Kerr ellipticity ($\eta$) are detected.

On the other hand, the signals of the P component and the S component are also supplied to an amplifier 34 and amplified. As a result, reproduced signals based on variation of the reflectance (R) of the reflected light from the recording medium are detected.

In this method 1, the magnetooptical recording film 3 is designed so that the variation of the Kerr ellipticity becomes larger than the variation of the Kerr rotation angle, and hence the reproduced signals can be obtained based on the variation of the Kerr ellipticity ($\eta$). Recording of information on the magnetooptical recording film is carried out by irradiating the recording medium 2 with a laser beam to raise a temperature on the irradiated area, so as to invert the magnetization direction of domain by supplying the external magnetic field.

On the other hand, the phase changing film 4 is designed so that the reflectance (R) of the film varies in accordance with variation of the optical constants $N_1$, $N_2$, and hence the reproduced signals can be obtained based on the reflectance. Recording of information on the phase changing film is carried out by irradiating the recording medium with a strong pulsed laser for a short period of time to rapidly heat the recording material at a temperature not lower than the melting point of the material and then rapidly cooling the recording material to fix the disordered atomic configuration so as to make the irradiated area amorphous.

Next, the method 2 is described below in detail.

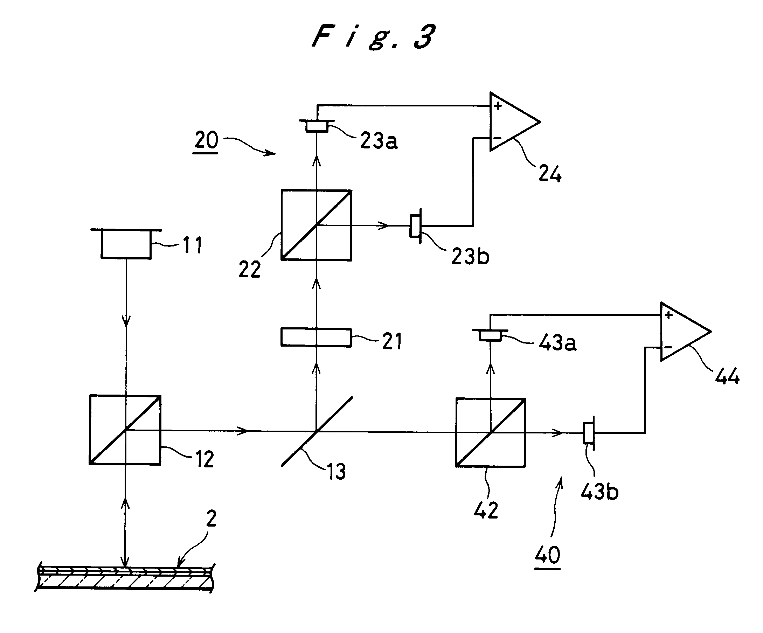

In this signal detection method, such optical system as shown in Fig. 3 is employed. A linearly polarized light released from a laser source 11 impinges on a beam splitter 12. A part of the light is transmitted by the beam splitter 12 and is focused on an optical recording medium 2 by means of a objective lens (not shown). A reflected light from the recording medium 2 is split into a first branch light and a second branch light by means of a half mirror 13. The first branch light is brought into a first optical detection system 20, and in this system detection of a signal based on the Kerr ellipticity is carried out. On the other hand, the second branch light is brought into a second optical detection system 40, and in this system detection of a signal based on the Kerr rotation angle is carried out.

The first optical detection system is the same as the optical system shown in Fig. 1. In this optical system, the first branch light is directed to a $\lambda$/4 plate 21, and the linearly polarized light is converted into a circular polarized light. Then, the circular polarized light is directed to a polarization beam splitter 22, and the circular polarized light is split into a P component and a S component by the polarization beam splitter. The P component and the S component are detected by means of photosensitive detectors 23a and 23b, respectively.

Then, the signals of the P component and the S component are differentially amplified by means of a differential amplifier 24, and as a result, reproduced signals based on the Kerr ellipticity ($\eta$) are detected.

On the other hand, in the second optical detection system 40, the second branch light is directed from the half mirror 13 to a polarization beam splitter 42. This polarization beam splitter is configured at an azimuth of approx. 45°. Owing to thus configured polarization beam splitter, the second branch light is split into a P component and a S component.

The P component and the S component are detected by means of photosensitive detectors 43a and 43b, respectively. Then, the signals of the P component and the S component are differentially amplified by means of a differential amplifier 44, and as a result, reproduced signals based on the Kerr rotation angle are detected. Further, a $\lambda$/2 plate configured at an azimuth of approx. $\pi$/8 may be inserted between half mirror and a polarization beam splitter configured at an azimuth of approx. 0°.

As described above, the optical recording medium can vary the Kerr ellipticity and the Kerr rotation angle individually, and hence two kinds of reproduced signals, one being based on the Kerr ellipticity and the other being based on the Kerr rotation angle, can be simultaneously obtained from the same spot of one optical recording medium.

The present inventors have further studied on the methods for reproducing multi-level signals using the above-mentioned signal detection method based on the Kerr ellipticity in combination with other detection method, and they have found the following method for reproducing multi-level signals.

3. A method in which information is detected based on the Kerr rotation angle ($\theta_k$) from the magnetooptical recording film 3 and information is also detected based on the reflectance (R) from the phase changing film 4.

The method 3 is illustrated below in detail.

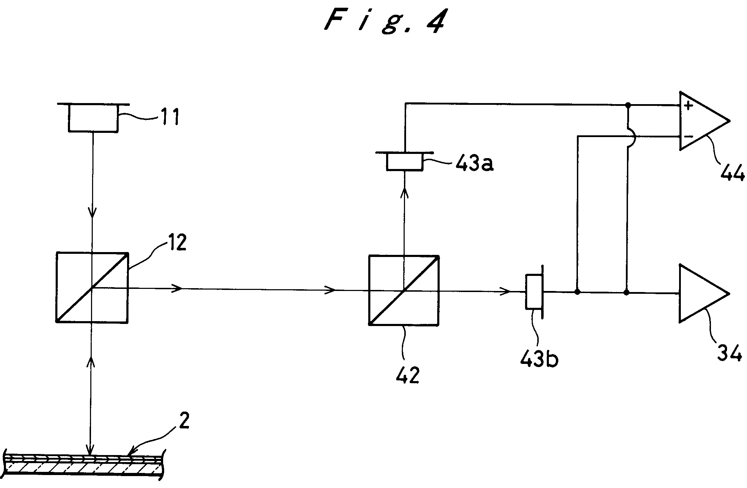

In this signal detection method, such optical system as shown in Fig. 4 is employed. A linearly polarized light released from a laser source 11 impinges on a beam splitter 12. A part of the light is transmitted by the beam splitter 12 and is focused on an optical recording medium 2 by means of a objective lens (not shown). A reflected light from the optical recording medium 2 contains information based on the Kerr rotation angle ($\theta_k$) in the magnetooptical recording film 3 and information based on the reflectance (R) in the phase changing film 4.

The reflected light is directed to a polarization beam splitter 42 by way of a beam splitter 12. This polarization beam splitter 42 is configured in such a manner that an azimuth $\theta$ thereof satisfies the condition of $40°+90°\times n_3 \leqq \theta \leqq 50°+90°\times n_3$ and preferably is approx. $45°+90°\times n_3$. Owing to thus configured polarization beam splitter 42, the reflected light is split into a P component and a S component. The P component and the S component are detected by means of photosensitive detectors 43a and 43b, respectively.

Then, the signals of the P component and the S component are differentially amplified by means of a differential amplifier 44, and as a result, reproduced signals based on the Kerr rotation angle ($\theta_k$) are detected.

On the other hand, the signals of the P component and the S component are also supplied to an amplifier 34 and amplified. As a result, reproduced signals based on variation of the reflectance (R) of the reflected light from the recording medium are detected.

In this method 3, the magnetooptical recording film 3 is designed so that the variation of the Kerr rotation angle becomes larger than the variation of the Kerr ellipticity, and hence the reproduced signals can be obtained based on the variation of the Kerr rotation angle. Recording of information on the magnetooptical recording film is carried out by irradiating the recording medium 2 with a laser beam to raise a temperature on the irradiated area, so as to invert the magnetization direction of domain by supplying the external magnetic field.

On the other hand, the phase changing film 4 is designed so that the reflectance (R) of the film varies in accordance with variation of the optical constants $N_1$, $N_2$, and hence the reproduced signals can be obtained based on the reflectance. Recording of information on the phase changing film is carried out by irradiating the recording medium with a strong pulsed laser for a short period of time to rapidly heat the recording material at a temperature not lower than the melting point of the material and then rapidly cooling the recording material to fix the disordered atomic configuration so as to make the irradiated area amorphous.

The optical recording medium 2 of the invention which is used in such a multi-level signal detection method as illustrated in the above methods 1 to 3 has a laminated film composed of a magnetooptical recording film 3 and a phase changing film 4 as a recording layer.

That is, the optical recording medium 2 according to the present invention has, as shown in Fig. 5, at least a magnetooptical recording film where information is recorded or reproduced based on a direction of magnetization and a phase changing film where information is recorded or reproduced based on variation of an optical constant caused by phase change between crystalline phase and amorphous phase, formed in this order on a substrate.

Further, the optical recording medium has such a structure that the information of the magnetooptical recording film 3 and the information of the phase changing film 4 can be recorded and reproduced indivisually on the same spot of one recording medium. Recording of information on the magnetooptical recording film is carried out by irradiating the recording medium 2 with a laser beam to raise a temperature on the irradiated area, so as to invert the magnetization direction of domain by supplying the external magnetic field, and reproduction of information from the magnetooptical recording film 3 is carried out based on not only the Kerr ration angle ($\theta_k$) but also the Kerr ellipticity ($\eta$). Recording of information on the phase changing film is carried out by irradiating the recording medium with a strong pulsed laser for a short period of time to rapidly heat the recording material at a temperature not lower than the melting point of !he material and then rapidly cooling the recording material to fix the disordered atomic configuration so as to make the irradiated area amorphous, and reproduction of information from the phase changing film 4 is carried out based on not only the reflectance (R) but also the Kerr ellipticity ($\eta$).

## Magnetooptical recording film

The magnetooptical recording film 3 is composed of, for example,

(A) an alloy comprising (i) at least one metal selected from 3d transition metals and (iii) at least one element selected from rare earth elements,

(B) an alloy comprising (i) at least one metal selected from 3d transition metals, (ii) corrosion-resistant metal and (iii) at least one element selected from rare earth elements,

(C) an alloy comprising (i) at least one metal selected from 3d transition metals and (ii) corrosion-resistant metal,

(D) Pt/Co composition modulated film, or

(E) Pd/Co composition modulated film.

The magnetooptical recording film used in the present invention is, however, by no means restricted to the above-mentioned embodiments.

Examples of the 3d transition metals (i) include Fe, Co, Ti, V, Cr, Mn, Ni and Zn. This 3d transition metal is contained in the alloy film of (A) or (B) in an amount of 20-90 atom%, preferably 30-85 atom%. While, in the alloy film of (C), the 3d transition metal is preferably contained in an amount of 10-60 atom%.

Examples of the rare earth elements (iii) include Gd, Tb, Dy, Ho, Er, Tm, Nd, Sm and Pr. This rare earth element is contained in the alloy film of (A) or (B))in an amount of 5-50 atom%, preferably 8-45 atom%.

Examples of the corrosion-resistant metals include Pt, Pd, Ti, Zr, Ta and Nd. This corrosion-resistant metal is contained in the alloy film of (B) in an amount of not more than 30 atom%, preferably 5-25 atom%, while in the alloy film of (C), the corrosion-resistant metal is contained in the amount of 90-40 atom%.

Particularly, the magnetooptical recording medium suitable for the method of utilizing the Kerr ellipticity preferably comprises TbFe, TbCo, TbFeCo, GdFe, GdCo, GdFeCo, GdTbFe, GdTbCo, GdTbFeCo, NdFe, NdCo, NdTbFe, NdTbCo, NdTbFeCo, DyFe, DyCo, DyTbFe, DyTbCo, DyTbFeCo, CoPt or CoPd.

This magnetooptical recording film 3 has a film thickness of preferably 50-600 Å, more preferably 50-400 Å, most preferably 50-350 Å or thereabouts.

Phase changing film

The phase changing film may be any film as far as the optical constant of the film varies in accordance with phase change of the film. Useful as the phase changing film are recording films of TeO, TeGeO, TeGeSn, TeGeOSn, TeGe, TeGeSe, TeGeSb, TeGeSeSb, InSe, InSeTlCo, SbTe, SnTeSe, GaSeTe, GaSeTeGe, BiTe and SbSe.

Design of optical recording medium

In the magnetooptical recording film (MO film), the direction of magnetization varies between upward direction and downward direction, while in the phase changing recording film, the optical constant (N) varies between $N_1$ and $N_2$ depending on whether the film is in a crystalline phase or in an amorphous phase. Accordingly, the magnetic Kerr effect of the optical recording medium can be classified as shown in the following table by combining the direction of magnetization and the optical constant.

| | Magnetization direction of MO film | |
|---|:---:|:---:|
| N of Phase changing film | ↑ | ↓ |
| $N_1$ | $\theta_{k1}$ $\eta_{k1}$ | $-\theta_{k1}$ $-\eta_{k1}$ |
| $N_2$ | $\theta_{k2}$ $\eta_{k2}$ | $-\theta_{k2}$ $-\eta_{k2}$ |

If the optical recording medium is designed utilizing the interference structure in such a manner that a relationship between $\eta_{k1}$ and $\eta_{k2}$ and a relationship between $\theta_{k1}$ and $\theta_{k2}$ are $\eta_{k1} \neq \eta_{k2}$ and $\theta_{k1} \doteqdot \theta_{k2}$, respectively, a degree of $\theta_k$ differs correspondingly to the upward or downward direction of the magnetization, and further a degree of $\eta_k$ varies correspondingly to the optical constant. Hence, the upward or downward direction of the magnetization and the difference of the optical constant can be detected separately.

The Kerr ellipticity ($\eta_k$) and the Kerr rotation angle ($\theta_k$) can be calculated from the optical constants (refractive index n and extinction coefficient k) of the substrate, the magnetooptical recording film, the phase changing film and the dielectric film used in the optical recording medium, the constitution of the optical recording medium, etc. Therefore, it is possible to design such optical recording medium as has a relationship between $\eta_{k1}$ and $\eta_{k2}$ of $\eta_{k1} \neq \eta_{k2}$ and a relationship between $\theta_{k1}$ and $\theta_{k2}$ of $\theta_{k1} \fallingdotseq \theta_{k2}$ by appropriately selecting and determining the parameters of them.

For example, the following optical recording medium is supposed.

Wavelength of laser: $\lambda$ = 830 (nm)

Phase changing film:

amorphous:      n = 4.08, k = 1.73

crystalline:      n = 1.68, k = 3.09

Magnetooptical (MO) film:

n = 3.67, k = 3.86

$\Delta$n = 0.11, $\Delta$k = 0.13

$\Delta$n, $\Delta$k: difference in a dextrotary circular polarized light and left

SiN:                n = 2.00, K = 0

Glass substrate:      n = 1.50

Constitution of the optical recording medium:

Substrate/SiN (1,000 Å)/MO (65 Å)/SiN (280 Å)/Phase changing film (1,000 Å)

From the above-described parameters, $\theta_k$ and $\eta_k$ can be obtained as shown in the following table.

| | Magnetization direction of MO film | |
|---|---|---|
| N of Phase changing film | ↑ | ↓ |
| $N_1 = 4.08 - i1.73$ | $\theta_k = 1.3$ deg.<br>$\eta_k = 0$ | $\theta_k = -1.3$ deg.<br>$\eta_k = 0$ |
| $N_2 = 1.68 - i3.09$ | $\theta_k = 1.3$ deg.<br>$\eta_k = -0.95$ deg. | $\theta_k = -1.3$ deg.<br>$\eta_k = 0.95$ deg. |

## EFFECT OF THE INVENTION

According to the present invention, the reproduced signals can be obtained utilizing the Kerr ellipticity $\eta$, and further the obtained reproduced signals are excellent in an S/N ratio because the signals of the P component and the S component are differentially amplified to detect the reproduced signals. Moreover, the optical detection system used in the invention is composed only of a quarter-wave plate and a polarization beam splitter, and thereby the constitution of the optical detection system is very simple.

In addition, the signal detection method based on the Kerr ellipticity can be used in combination with other signal detection methods based on the Kerr rotation angle or the reflectance. Accordingly, two kinds of signals one of which is based on the Kerr ellipticity and the other of which is based on the Kerr rotation angle or the reflectance can be simultaneously obtained from the same spot of one optical recording medium, with the proviso that the recording medium is able to be varied in the Kerr ellipticity and the Kerr rotation angle (or the reflectance) separately. That is, signals of 2 bits (four-level signals) can be recorded on or reproduced from the same spot of one optical recording medium. This means that recording of information on a recording medium with high density is possible.

Further, the signal detection method based on the Kerr ellipticity and the signal detection method based on the reflectance can be used in combination, whereby detection of multi-level signals becomes possible. This also means that it is possible to record information with high density.

According to the invention, moreover, an optical recording medium capable of being recorded with multi-level signals and suitably used for the above-mentioned signal detection methods can be provided.

## Claims

1. A method of detecting information recorded on a magnetooptical recording medium, which comprises:
   irradiating the magnetooptical recording medium with a linearly polarized light, causing the reflected light from the medium to be split into a P component and a S component, detecting the P component and the S component individually by a photosensitive detector, and differentially amplifying signals of the P component and the S component by a differential amplifier to detect the reproduced signals.

2. A method of detecting information recorded on an optical recording medium, which comprises:
   irradiating the optical recording medium with a linearly polarized light, causing the reflected light from the medium to be split into a P component and a S component, detecting the P component and the S component individually by a photosensitive detector, differentially amplifying signals of the P component and the S component by a differential amplifier, and detecting the reproduced signals based on Kerr ellipticity to obtain the information recorded on the optical recording medium;
   while, detecting the reproduced signals based on variation of a reflectance of the reflected light from the signals of the P component and the S component to obtain the information recorded on the optical recording medium.

3. A method according to claim 1 or 2 wherein the reflected light is split into P or S components by being transmitted by a quarter-wave plate which is configured at an azimuth of approximately $45°+(90°*n_1)$, wherein $n_1$ is an integer, then causing the transmitted light to enter into a polarisation beam splitter which is configured at an azimuth of approximately $90°*n_2$, wherein $n_2$ is an integer.

4. A method of detecting information recorded on an optical recording medium, which comprises:
   irradiating the optical recording medium with a linearly polarized light, splitting the reflected light from the medium into a first branch light and a second branch light by a half mirror, causing the first branch light to be transmitted by a quarter-wave plate which is configured at an azimuth of approximately $45°+(90°*n_1)$, wherein $n_1$ is an integer, then causing the transmitted light to enter into a polarization beam splitter which is configured at an azimuth of approximately $90°*n_2$, wherein $n_2$ is an integer, to split the light into a P component and a S component, detecting the P component and the S component individually by a photosensitive detector, and differentially amplifying signals of the P component and the S component by a differential amplifier to detect the reproduced signals based on Kerr ellipticity;
   while, causing the second branch light to enter into a polarization beam splitter which is configured at an azimuth of approximately $45°+90°×n_3$, wherein $n_3$ is an integer, to split the light into a P component and a S component, detecting the P component and the S component individually by a photosensitive detector, and differentially amplifying signals of the P component and the S component by a differential amplifier to detect the reproduced signals based on Kerr rotation angle.

5. A method of detecting a reproduced signal from an optical recording medium, which comprises:
   irradiating the optical recording medium with a linearly polarized light, causing the reflected light from the medium to enter into a polarization beam splitter which is configured at an azimuth of approximately $45°+90°×n_3$, wherein $n_3$ is an integer, to split the light into a P component and a S component, detecting the P component and the S component individually by a photosensitive detector, differentially amplifying signals of the P component and the S component by a differential amplifier, and detecting the reproduced signals based on Kerr rotation angle to obtain the information recorded on the optical recording medium;
   while, detecting the reproduced signals based on variation of a reflectance of the reflected light from the signals of the P component and the S component to obtain the information recorded on the optical recording medium.

6. The information detecting method as claimed in any of claims 2 to 5, wherein the optical recording medium is an optical recording medium having at least a magnetooptical recording film where information is recorded or reproduced based on a direction of magnetization and a phase changing film where information is recorded or reproduced based on variation of an optical constant caused by phase change between crystalline phase and amorphous phase, formed in this order on a substrate.

7. An optical recording medium which has at least a magnetooptical recording film where information is recorded or reproduced based on a direction of magnetization and a phase changing film where information is recorded or reproduced based on variation of an optical constant caused by phase change between crystalline phase and amorphous phase, formed in this order on a substrate.

8. An apparatus for detecting information from an optical or magneto-optical recording medium adapted to carry out the steps of the methods of any one of claims 1 to 6.

# Fig. 1

EP 0 523 900 A2

Fig.2

Fig. 3

EP 0 523 900 A2

# Fig. 4

# F i g. 5